Europäisches Patentamt

European Patent Office

Office européen des brevets

(19)

(11) **EP 1 169 650 B1**

(12) **EUROPÄISCHE PATENTSCHRIFT**

(45) Veröffentlichungstag und Bekanntmachung des Hinweises auf die Patenterteilung:
**29.09.2004  Patentblatt 2004/40**

(21) Anmeldenummer: **00988643.3**

(22) Anmeldetag: **24.11.2000**

(51) Int Cl.$^7$: **G01P 15/08**, B81B 3/00

(86) Internationale Anmeldenummer:
**PCT/DE2000/004171**

(87) Internationale Veröffentlichungsnummer:
**WO 2001/044822 (21.06.2001 Gazette 2001/25)**

(54) **UNTERSCHIEDLICHE OPFERSCHICHTDICKEN UNTER FESTEN UND BEWEGLICHEN ELEKTRODEN ( KAPAZITIVER BESCHLEUNIGUNGSSENSOR )**

DIFFERENT SACRIFICIAL LAYER THICKNESS UNDER FIXED AND MOVABLE ELECTRODES (CAPACITIVE ACCELERATION SENSOR)

DIFFERENCE D'EPAISSEUR DE COUCHES SACRIFICIELLES SOUS DES ELECTRODES FIXES ET MOBILES (CAPTEUR D'ACCELERATION CAPACITIF)

(84) Benannte Vertragsstaaten:
**DE FR GB NL**

(30) Priorität: **14.12.1999  DE 19960094**

(43) Veröffentlichungstag der Anmeldung:
**09.01.2002  Patentblatt 2002/02**

(73) Patentinhaber: **ROBERT BOSCH GMBH**
**70442 Stuttgart (DE)**

(72) Erfinder:
 • **BANJAC, Branko**
  **70794 Filderstadt (DE)**
 • **FISCHER, Frank**
  **72810 Gomaringen (DE)**
 • **SCHIELEIN, Doris**
  **72810 Gomaringen (DE)**
 • **BUECHE, Dirk**
  **88400 Biberach (DE)**

(56) Entgegenhaltungen:
DE-A- 19 526 691          DE-A- 19 734 113
DE-C- 19 730 715          US-A- 5 550 090
US-A- 5 783 749

EP 1 169 650 B1

## Beschreibung

Stand der Technik

Die Erfindung betrifft ein Verfahren zur mikromechanischen Herstellung von über einen bestimmten Bereich über einem Substrat freiliegenden schichtförmigen festen und beweglichen Elektroden eines Halbleiterelements, insbesondere eines kapazitiven Beschleunigungssensor, wobei durch einen Ätzschritt eine zwischen dem Substrat und den festen und beweglichen Elektroden liegende Opferschicht entfernt wird, um die Elektroden gegenüber dem Substrat freizulegen, sowie dessen Benutzung zur Herstellung eines Beschleunigungssensors.

Bei der Herstellung von Halbleiterelementen in Mikromechaniktechnologie, wie z. B. Beschleunigungs- und Drehratensensoren, wird eine Opferschicht aus Siliciumdioxid selektiv zu den aus Silicium bestehenden funktionalen Bauelementkomponenten geätzt. Dieser reaktive Abtrag des Opferoxids findet in der Gasphase über einem azeotropen Gemisch aus $H_2O$ und HF statt (M. Offenberg, et. al: "Acceleration Sensor in Surface Micromachining for Airbag Applications with High Signal/Noise Ratio"; Sensors and Actuators, 1996, 35 und DE-4 317 274.1.

Bei ungenügendem Prozessfortschritt bleiben Oxidreste unterhalb der funktionalen Bauelementeschicht stehen, was bei Sensoren, z. B. Beschleunigungssensoren mit einseitig eingespannten festen Elektrodenfingern zu Störungen und ungenauem Ansprechverhalten führt. Diese Reste entstehen an technologisch unbegünstigten Stellen, die dadurch ausgezeichnet sind, dass die darüberliegende Funktionsschicht nach dem Opferschichtätzen durch den intrinsischen Spannungsgradienten von der Ätzfront nach oben gewölbt wird und im Zustand bei Prozessende der Abstand zwischen Strukturschichtunterseite und der Opferschichtoberseite vergrößert ist. Dagegen liegen technologisch begünstigte Stellen derart, dass der Abstand zwischen der Oberfläche der Opferschicht und der Unterseite der Strukturschicht unter beidseitig verankerten Bauelementkomponenten, wie beispielsweise der federnd aufgehängten seismischen Masse eines Beschleunigungssensors, durch den intrinsischen Spannungsgradienten verringert wird. Dadurch ergibt sich eine erhöhte Ätzrate. Es entsteht somit eine starke Inhomogenität der Ätzrate innerhalb einer Sensorstruktur, die unter festen Elektroden zu Oxidresten führt und an anderer Stelle starke Unterätzung hinterlässt.

Die stark inhomogene Ätzrate unter den festen, einseitig eingespannten Elektrodenfingern und der beweglichen Mittelmasse eines Beschleunigungssensors führt bei der Massenfertigung solcher Beschleunigungssensoren zu einem schwer definierbaren Abbruchkriterium des Ätzprozesses. Es kommt dazu, dass es an manchen Stellen im Bauelement, beispielsweise den elektrischen Zuleitungen, zu einer starken unerwünschten unterätzung kommt, wohingegen im Bereich des Sensorkerns unter den festen Elektroden noch starke Oxidreste existieren, die die Funktionalität der Sensorstruktur beeinträchtigen.

Aufgabe und Vorteile der Erfindung

Im Hinblick auf das Problem der mikroskopisch inhomogenen Ätzrate bei der Herstellung von Halbleiterelementen, bei denen durch Opferschichtätzung schichtförmige Elektrodenbereiche freigelegt werden, wie beispielsweise bei den festen kammartigen Elektroden eines Beschleunigungssensors soll ein erfindungsgemäßes Verfahren die mikromechanische Herstellung solcher Bauelemente ermöglichen, bei denen die Ätzrate beim selektiven isotropen Ätzen von Siliciumdioxid in einer $H_2O$/HF-Gasphase auf mikroskopischer Skala homogenisiert werden kann.

Diese Aufgabe wird anspruchsgemäß gelöst.

Kern der Erfindung ist eine Reduzierung der Opferoxidschichtdicke unter den festen, einseitig eingespannten Elektrodenfingern. Dadurch wird an diesen Stellen die Ätzrate kinetisch bedingt deutlich erhöht und auf diese Weise an die Ätzrate unter der seismischen Masse angenähert. Die Reduzierung der Opferoxiddikke unter den festen Elektrodenfingern wird durch eine entsprechende Verdickung der über den Opferschichten aufgebauten Epitaxieschicht aus polykristallinem Silicium erzielt, aus denen die später freigeätzten Elektrodenfinger bestehen.

Durch die Anpassung der Ätzrate unter der seismischen Masse und den festen Elektrodenfingern wird die Gesamtdauer des Gasphasenätzprozesses (GPÄ) deutlich reduziert. Durch diese Maßnahme wird weiterhin eine verbesserte Homogenität des Oxidabtrages der Opferschicht oder der Opferschichten innerhalb eines Halbleiterelements, insbesondere einer Beschleunigungssensorstruktur, über den gesamten Wafer gesehen, erreicht.

Gemäß einem wesentlichen Aspekt der Erfindung ist ein Verfahren zur mikromechanischen Herstellung von über einen bestimmten Bereich über einem Substrat freiliegenden schichtförmigen festen und beweglichen Elektroden eines Halbleiterelements, insbesondere eines kapazitiven Beschleunigungssensor, wobei durch einen Ätzschritt eine zwischen dem Substrat und den festen und beweglichen Elektroden liegende Opferschicht entfernt wird, um die Elektroden gegenüber dem Substrat freizulegen, dadurch gekennzeichnet, dass die Dicke der im Bereich der festen Elektroden liegenden Opferschicht geringer ist, als die Dicke der im Bereich der beweglichen Elektroden liegenden Opferschicht.

Bei einem Ausführungsbeispiel des erfindungsgemäßen Verfahrens ist nach der Opferschichtätzung die Dicke der festen Elektroden größer als die Dikke der beweglichen Elektroden. Durch die Verdickung der festen Elektrodenfinger einer solchen Sensorstruktur stellt sich folgender Effekt ein:

bei gleichen Schichtdicken der funktionalen Strukturen würde die effektive, kapazitiv wirksame Elektrodenfläche verkleinert, da ein fester Elektrodenfinger aufgrund des Stressgradienten nach oben gebogen wird. Da sich gleichzeitig die beidseitig eingespannte seismische Masse nach unten wölbt, würde sich die Elektrodenfläche der sich gegenüberstehenden Elektroden effektiv verkleinern.

Bei der gemäß dem ersten Ausführungsbeispiel der Erfindung größeren Dicke der festen Elektroden gegenüber der Dicke der beweglichen Elektroden steht dagegen die Mittelmasse selbst bei einem hohen Stressgradienten noch der Gegenelektrode gegenüber.

Bei dem erfindungsgemäß vorgeschlagenen Schichtaufbau besteht die unter einem Bereich der festen Elektroden liegende Opferschicht aus einer ersten Opferschicht, und die unter einem Bereich der beweglichen Elektroden liegende Opferschicht besteht aus der genannten ersten Opferschicht und einer unmittelbar darüberliegenden zweiten Opferschicht.

Bei dem erfindungsgemäßen Herstellungsverfahren sind im einzelnen die nachstehenden, aufeinanderfolgenden Schritte vorgesehen:

a) über dem Substrat wird die erste Opferschicht ganzflächig so aufgebracht, dass sie die Bereiche der späteren festen und beweglichen Elektroden überdeckt;

b) über der ersten Opferschicht wird eine erste leitfähige Schicht so aufgebracht, dass sie nur den Bereich der späteren festen Elektroden überdeckt;

c) über der ersten Opferschicht und der ersten leitfähigen Schicht wird die zweite Opferschicht ganzflächig so aufgebracht, dass sie die Bereiche der späteren festen und beweglichen Elektroden überdeckt;

d) die zweite Opferschicht wird durch einen maskierten Ätzschritt über der ersten leitfähigen Schicht geöffnet, so dass die erste leitfähige Schicht freigelegt wird und die erste Opferschicht in der Tiefe nur geringfügig abgetragen wird;

e) über der zweiten Opferschicht und der in Schritt d) freigelegten leitfähigen Schicht wird ganzflächig eine verhältnismäßig dicke dotierte Epitaxieschicht bis zur Höhe der später zu bildenden festen und beweglichen Elektroden aufgebracht;

f) auf der Oberfläche der Epitaxieschicht wird eine die festen und beweglichen Elektroden strukturierende Maske aufgebracht, und unter Verwendung der Maske werden Gräben in die Epitaxieschicht bis in eine Tiefe geätzt, die im Bereich der festen Elektroden durch die Oberfläche der ersten Opferschicht und im Bereich der beweglichen Elektroden durch die Oberfläche der zweiten Opferschicht begrenzt ist, und

g) die erste und zweite Opferschicht werden isotrop geätzt, wobei annähernd gleiche Unterätzraten der Opferschicht unter den festen Elektroden und der Opferschichten unter den beweglichen Elektroden entstehen.

Bevorzugt liegt die Dicke der ersten Opferschicht im Bereich von 0,5-5 μm und die Dicke der zweiten Opferschicht im Bereich von 0,5-3 μm.

Weiterhin beträgt die Dicke der festen Elektroden von 1,5-20 μm und die festen und beweglichen Elektrodenstreifen oder -finger eines erfindungsgemäß hergestellten Beschleunigungssensors haben eine Breite im Bereich von 1-5 μm.

Bei einem alternativen Ausführungsbeispiel des erfindungsgemäßen Verfahrens kann sowohl die Dicke der seismischen Masse als auch der festen Elektrodenfinger im Bereich des Sensorkerns im gleichen Maß vergrößert werden. Dabei ist darauf zu achten, dass die Opferschichtdicke im Bereich der Aufhängungen nicht erniedrigt wird. Hierbei wird die Funktionsschicht über eine Brücke an die Leiterbahn unter der festen Elektrode angeschlossen. Diese mechanische Verbindung wird beim Gasphasenätzen dadurch nicht destabilisiert, dass die Opferschicht unter den beweglichen Elektrodenstrukturen dicker als im Bereich unter den festen Elektrodenstrukturen ist.

Ein mit dem erfindungsgemäßen Verfahren hergestellter Beschleunigungssensor weist ausgehend von einer federnd aufgehängten, als Mittelbalken ausgeführten beweglichen Masse, mehrere bewegliche Elektroden abwechselnd mit diesen Elektroden jeweils gegenüberliegenden festen, beidseitig oder einseitig eingespannten Elektroden auf. Die einseitig eingespannten Elektroden haben an ihrem vom Mittelbalken der beweglichen Masse abgewendeten Ende einen leitenden sie verbindenden Elektrodenstreifen, der senkrecht zur Richtung der Zinken der kammförmigen Elektroden verläuft.

Dadurch dass erfindungsgemäß die Ätzrate unter den festen Elektroden und der beweglichen Mittelmasse ausgeglichen ist, können Beschleunigungssensoren oder Drehratesensoren in Massenfertigung bei erheblich verbesserter Ausbeute und mit höherer Zuverlässigkeit hergestellt werden.

Die obigen und weitere vorteilhafte Merkmale der Erfindung werden aus der nachstehenden, auf die beiliegende Zeichnung bezugnehmenden Beschreibung deutlich.

Zeichnung

Figur 1 zeigt eine schematische ebene Draufsicht auf einen mit dem erfindungsgemäßen Verfahren herstellbaren Beschleunigungssensor.

Figur 2 zeigt graphisch einen prinzipiellen Verlauf der Ätzrate bei der Opferschichtätzung in Abhängigkeit von der Dicke der Opferschicht (Spaltdicke).

Die Figuren 3A-3H zeigen schematisch den Schichtaufbau in der Reihenfolge der Verfahrensschritte der Erfindung bei einem ersten Ausführungsbeispiel und zwar im Querschnitt entlang der Schnittlinie 3-3 in Figur 1, und

Figur 4 zeigt schematisch einen Querschnitt durch einen Beschleunigungssensor gemäß Figur 1 entlang der Schnittlinie 3-3 eines zweiten Ausführungsbeispiels der Erfindung.

Ausführungsbeispiele

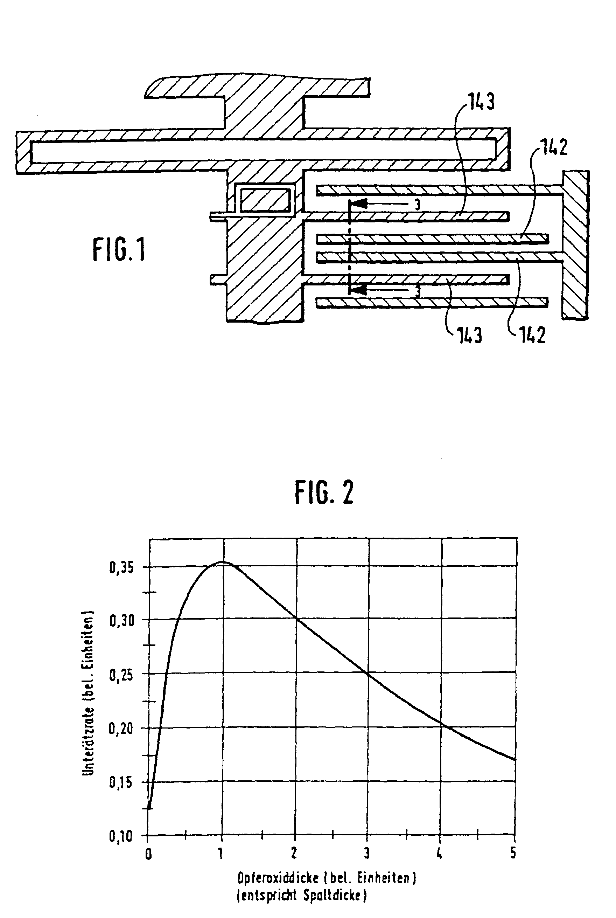

In Figur 1 ist ein mit einem erfindungsgemäßen Herstellungsverfahren herstellbarer kapazitiver Beschleunigungssensor in Form einer schematischen ebenen Draufsicht gezeigt. Der in Figur 1 gezeigte kapazitive Beschleunigungsmesser hat eine bewegliche zentrale Masse und davon ausgehende bewegliche Elektroden 143. Abwechselnd mit den beweglichen Elektroden 143 sind feste Elektroden 142 vorgesehen, die durch eine Leiterbahn verbunden sind. Die Elektroden werden bevorzugt aus dotiertem polykristallinem Silicium oder auch Germanium mit einer Dicke zwischen 1,5 und 20 μm hergestellt. Die Leiterbahnen bestehen aus dotiertem polykristallinem Silicium in einer Dicke zwischen 0,3 μm und 1μm. Die bewegliche Masse kann in Y-Richtung, d. h. in der in der Zeichenebene liegenden vertikalen Richtung, schwingen, wobei eine U-Feder den Schwingungsruhepunkt und eine Auslenkungsbegrenzung die maximale Auslenkung festlegt.

Durch die mit dieser Erfindung vorgeschlagene strukturelle Maßnahme wird erreicht, dass die Unterätzrate der Opferschicht bzw. der Opferschichten unter den festen Elektroden 142 und unter den an der beweglichen Masse sitzenden beweglichen Elektroden 143 angeglichen wird. Dadurch wird das Ätzverhalten homogenisiert und die Prozesszeit kann deutlich verkürzt werden. Ein Vorteil dieser Maßnahme ist auch, dass die Ätzrate nur im Bereich des Sensorkernes erhöht wird, nicht jedoch in Bereichen der elektrischen Zuleitung.

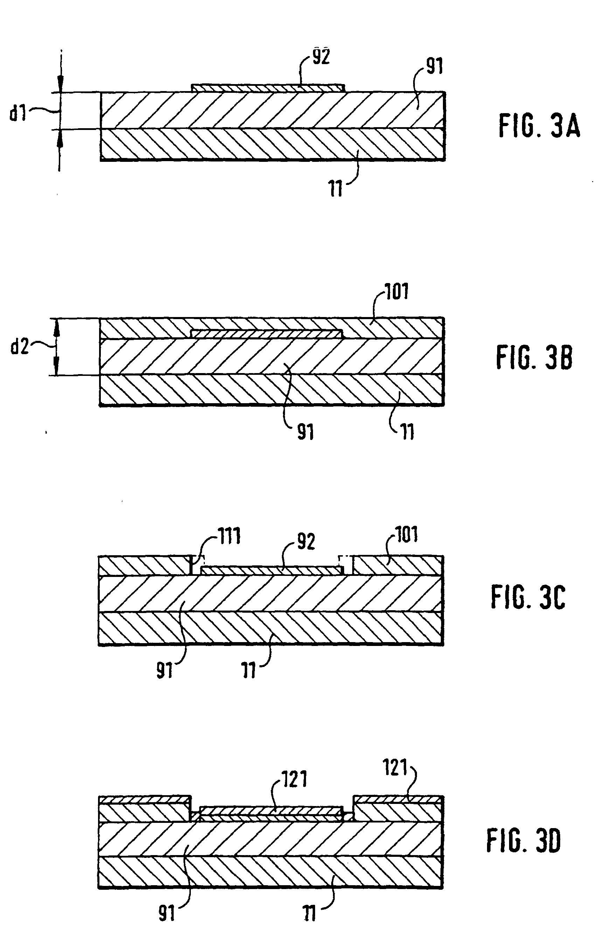

Bevor nun anhand der Figuren 3A-3H auf die Halbleiterschichtstruktur und die einzelnen Verfahrensschritte eingegangen wird, wird nachstehend die der Erfindung zugrundeliegende Problematik bei der Herstellung eines solchen Beschleunigungssensors, wie er in Figur 1 dargestellt ist, detailliert beschrieben.

Die Abtragrate beim selektiven isotropen Ätzen von $SiO_2$ in einer $HF$-$H_2O$-Gasphase wird bei dicken Oxiden (lateraler Angriff bei der Unterätzung von Strukturschichten) wie auch beim Angriff nicht strukturierter Oxidflächen (vertikaler Angriff auf freie Oxidflächen) durch die Konzentration der Reaktionspartner $HF$, $H_2O$ bestimmt. Der reaktive Angriff in der Gasphase kann vereinfacht mit folgenden Reaktionsgleichungen beschrieben werden:

$$(1) \qquad SiO_2 + 4HF + 2H_2O \rightarrow SiF_4 \uparrow + 4H_2O \uparrow$$

$$(2) \qquad SiO_2 + 6HF \rightarrow H_2SiF_6 + 2H_2O \uparrow$$

$$(3) \qquad H_2SiF_6 \rightarrow SiF_4 \uparrow + 2HF \uparrow$$

Bei der Reaktion mit $SiO_2$ wird $HF$ verbraucht. Das bei der Reaktion beteiligte Wasser initiiert den Ätzangriff von $SiO_2$ durch $HF$ gemäß Gleichung (1). Es liegt nach der Reaktion jedoch wiederum unverändert vor und kann erneut eine Reaktion gemäß Gleichung (1) eingehen.

Nahezu unabhängig von der mittleren Konzentration der Reaktionspartner in der Gasphase kann die Ätzrate durch Steuerung des kinetischen An- und Abtransports der Reaktanden an der Oberfläche beeinflusst werden. Eine Abhängigkeit von den kinetischen Bedingungen kann beim Ätzen von dünnen Oxiden beobachtet werden, die beispielsweise als Opferschicht unter Strukturschichten eingesetzt werden. Es zeigt sich, dass die laterale Ätzrate (Unterätzrate) abhängig von der Dicke der Opferschicht ist. So ist die Unterätzrate bei einem 1,6 μm dünnen $SiO_2$ ca. 1,5 mal höher als bei einem 4 μm dicken Oxid (siehe Figur 2).

Dieser Effekt kann damit begründet werden, dass das bei der Ätzreaktion von $SiO_2$ beteiligte $H_2O$ nur langsam aus dem von der Ätzfront freigelegten dünnen Spalt zwischen Substrat und Funktionsschicht austreten kann. Dadurch wird die rasche Reaktion gemäß Gleichung (1) bevorzugt ablaufen, wodurch sich eine starke Erhöhung der Ätzrate einstellt. Bei einem dicken Oxid wird der Abtransport von $H_2O$ nur wenig durch die Spaltgeometrie behindert, was zu einer geringeren Ätzrate beiträgt als im Fall eines dünnen Oxids.

Figur 2 zeigt einen prinzipiellen Verlauf der Ätzrate mit der Opferoxiddicke.

Dieser Effekt macht sich beim Ätzen von mikromechanischen Strukturen, wie beispielsweise bei der Herstellung eines in Figur 1 gezeigten Beschleunigungssensors bemerkbar und kann zu einer starken Inhomogenität der Unterätzrate innerhalb eines Sensorelementes führen.

Dieser Effekt hat sich auch bei elektronenmikroskopisch aufgenommenen Schliffproben von Beschleunigungssensoren gezeigt. Hier zeigt es sich typischerweise, dass unter der mittleren beweglichen Masse das Opferoxid beim Gasphasenätzen vollständig entfernt wurde. Dagegen zeigten sich bei freistehenden einseitig aufgehängten Elektroden noch große Reste nicht geätzten Oxids. Diese Oxidreste treten ausschließlich unter den Enden der festen Elektroden auf.

Unter Berücksichtigung der Abhängigkeit der Unterätzrate vom kinetisch bedingten Abtransport vom Wasser kann die mikroskopische Inhomogenität der Ätzrate unter der Struktur eines Beschleunigungssensors verstanden werden.

In einem realen Bauelement führt außerdem der Stressgradient in der Strukturschicht bei einer einseitig eingespannten streifenförmigen Elektrode (Balken) zu einer Verbiegung nach oben, da das eine Ende frei ist. Hierdurch wächst der Abstand zwischen dem Elektrodenstreifen und der Oxidfläche vor allem im Endbereich der Elektrodenfinger deutlich an, wodurch das bei der Reaktion beteiligte Wasser schneller austreten kann. Dadurch wird die Ätzrate stark erniedrigt, und es kann nach dem Prozessabbruch zu Oxidresten, insbesondere im Bereich der gebogenen festen Elektrodenkämme kommen.

Bei einem beidseitig eingespannten Balken wird der Abstand nach unten durch den Stressgradienten verringert, da sich der Balken mit seinem mittleren freien Abschnitt nach unten biegt; diesem Fall entspricht die an den beiden U-Federn angebundene bewegliche zentrale Masse. Hier können die Reaktionsprodukte nur langsam entweichen, wodurch sich die Ätzrate erhöht und die Wahrscheinlichkeit, dass Oxidreste nach dem Prozessabbruch verbleiben, gering ist.

Im Hinblick auf das oben erläuterte Problem der mikroskopisch inhomogenen Ätzrate wird eine Schichtstruktur vorgeschlagen, durch die die Unterätzraten im Bereich der einseitig eingespannten festen Elektroden und der beidseitig fixierten beweglichen seismischen Masse angeglichen werden können. Durch diese strukturelle Maßnahme wird die Ätzrate unter den festen Elektroden beschleunigt, wodurch sich eine Erniedrigung der gesamten Prozessdauer beim Gasphasenätzen um einen Faktor von 1,5 ergeben kann. Ein weiterer Vorteil dieser Maßnahme ist, dass die Unterätzung im Bereich ungeschützter Leiterbahnen im Vergleich zur Sensorstruktur reduziert wird.

Im Folgenden werden die erfindungsgemäße Schichtstruktur und die erfindungsgemäß ausgeführten Verfahrensschritte anhand der Figuren 3A-3H näher erläutert, die einen Querschnitt durch einen in Figur 1 gezeigten Beschleunigungssensor im Bereich des Sensorkerns längs der Schnittlinie 3-3 darstellt.

Zunächst zeigt Figur 3A, dass auf einem Substrat 11, beispielsweise Silicium, eine erste Opferschicht 91, die bevorzugt aus $SiO_2$ oder Phosphorsilikatglas besteht in einer Dicke d1, und eine erste leitfähige Schicht 92 auf der ersten Opferschicht 92 aufgebracht werden. Die leitfähige Schicht 92 wird durch bekannte Verfahren zu schmalen Streifen strukturiert. Diese Schicht kann in anderen Bereichen des Sensorelements als Leiterbahn dienen. Die Dicke d1 der ersten Opferschicht 91 kann zwischen 0,5 µm und 5 µm betragen. Die Leiterbahn 92 kann zwischen 0,3 µm und 1 µm dick sein.

In dem in Figur 3B gezeigten nächsten Schritt wird eine zweite Opferschicht 101 abgeschieden. Diese kann aus $SiO_2$ bestehen, das mit einem CVD-Verfahren hergestellt wird. Ihre Dicke sollte im Bereich zwischen 0,5 µm und 3 µm liegen.

Figur 3C zeigt, dass die zweite Opferschicht 101 mit einem maskierten Ätzschritt, bevorzugt durch reaktives Ionenätzen (RIE), geöffnet wird, um die Leiterbahn 92 freizulegen. Die dadurch entstandene Öffnung 111 kann dabei gleich groß, kleiner oder etwas größer als die Ausdehnung der Leiterbahn 92 sein. Beim Öffnen der zweiten Opferschicht 101 sollte darauf geachtet werden, dass nicht mehr als 0,5 µm von der ersten Opferschicht in die Tiefe abgetragen wird.

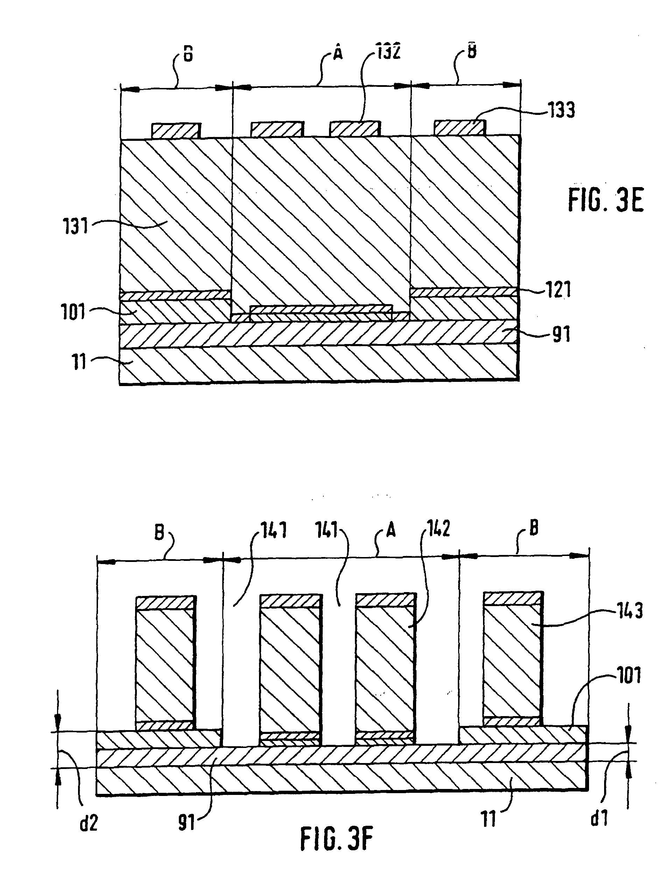

Figur 3D zeigt die Abscheidung einer dünnen, dotierten Nukleationsschicht 121 aus Silicium, die bei niedrigen Temperaturen abgeschieden wird, um die Abscheidung einer dicken Si-Schicht (Figur 3E) zu erleichtern.

Figur 3E zeigt, dass auf der gemäß Figur 3D abgeschiedenen Nukleationsschicht 121 eine dicke dotierte Epitaxieschicht 131 aus Silicium bei hohen Temperaturen abgeschieden wird. Dieser polykristalline Siliciumfilm 131 wird anschließend durch einen chemischmechanischen Polierschritt plan gemacht, so dass sich eine glatte Oberfläche der Schicht 131 ergibt. Auf dieser Oberfläche wird eine Maskierung 132, 133 strukturiert, die aus Fotolack, Oxid oder Metall bestehen kann. Hier ist zu erwähnen, dass diese Maskierung 132, 133 der Struktur jeweils der festen Elektroden 142 und der beweglichen Elektroden 143 (gemäß Figur 3F) entspricht. Gleichermaßen entspricht die Dimension der gemäß Figur 3C vorgenommenen Öffnung 111 in der zweiten Opferschicht 101 einem Bereich A der festen Elektroden 142, während der auf beiden Seiten der Öffnung 111 stehengebliebene Abschnitt der zweiten Opferschicht 101 jeweils einen Bereich B der beweglichen Elektroden 143 definiert.

Gemäß Figur 3F werden nun in einem anisotropen Ätzschritt tiefe Gräben 141 in die in Figur 3E aufgebaute Strukturschicht 131 geätzt. Der Ätzangriff stoppt im Bereich A der festen Elektroden 142 selektiv auf der ersten Opferschicht 91 und im Bereich B der beweglichen Elektroden 143 auf der zweiten Opferschicht 101. Hierdurch liegt unter den für die beweglichen Elektroden vorgesehenen Strukturschichtabschnitten (B) ein dickes Opferoxid (Dicke d2), das aus den Opferschichten 91 und 101 besteht, wohingegen innerhalb des Bereichs A unter den zur Ausbildung der festen Elektroden 142 vorgesehenen Strukturschichten nur das dünnere Oxid 91 (Dicke d1 < d2) liegt.

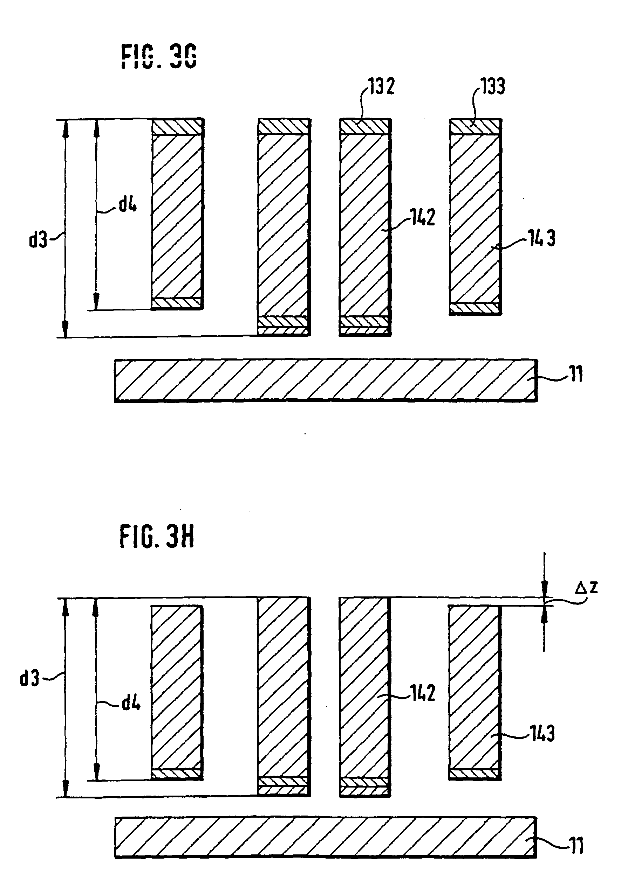

Anschließend werden die Opferschichten 91, 101 isotrop geätzt. Dabei führt die kinetisch bedingte Ätzratenerhöhung unter den festen Elektroden 142 zu einer raschen Unterätzung, die über der Unterätzrate im Bereich der beweglichen Elektroden 143 liegt. In den Figuren 3G und 3H sind die sich bei diesem Ausführungsbeispiel ergebende geringere Dicke d4 der beweglichen Elektroden 143 und die größere Dicke d3 der festen Elektroden 142 eingezeichnet.

In Figur 3H ist schließlich gezeigt, dass die auf zwei Seiten eingespannte bewegliche Elektrode 143 aufgrund des Stressgradienten der Strukturschicht um einen Weg $\Delta z$ nach unten gedrückt wird, wodurch sich hier eine erhöhte Ätzrate einstellt, die vergleichbar ist mit der Ätzrate unter den festen Elektroden 142.

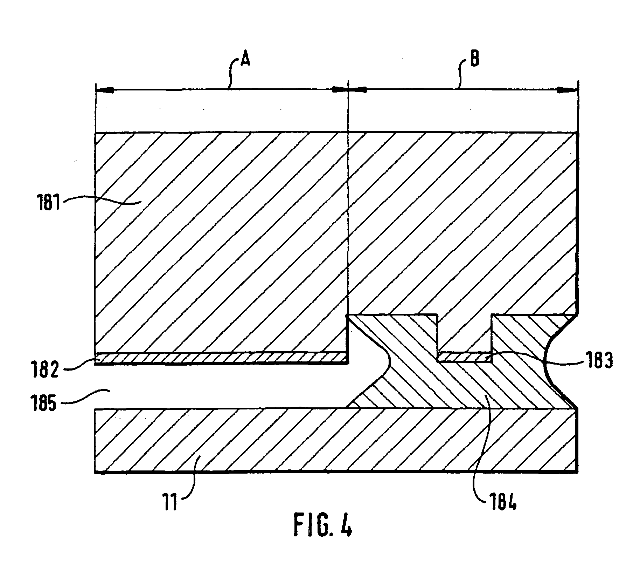

Figur 4 zeigt im Querschnitt die Struktur eines weiteren Ausführungsbeispiels der Erfindung, bei dem feste und bewegliche Elektroden gleicher Dicke erzielbar sind. Dabei kann sowohl die Dicke der seismischen Masse als auch der festen Elektrodenfinger im Bereich des Sensorkerns mit der erfindungsgemäßen Prozessfolge entsprechend den Figuren 3A-3H vergrößert werden. Dabei ist darauf zu achten, dass die Dicke der Opferschicht im Bereich von Aufhängungen nicht erniedrigt wird. Gemäß Figur 4 wird die Funktionschicht 181 über eine Brücke an die Leiterbahn 183 angeschlossen. Diese mechanische Anbindung wird beim Gasphasenätzen dadurch nicht destabilisiert, dass die Opferschicht 184 dicker als im Bereich 185 unter den Strukturen 182 ist.

**Patentansprüche**

1. Verfahren zur mikromechanischen Herstellung von über einen bestimmten Bereich über einem Substrat (11) freiliegenden schichtförmigen festen und beweglichen Elektroden (141, 143) eines Halbleiterelements, insbesondere eines kapazitiven Beschleunigungssensor, wobei

   durch einen Ätzschritt eine zwischen dem Substrat (11) und den festen und beweglichen Elektroden (142, 143) liegende Opferschicht entfernt wird, um die Elektroden (142, 143) gegenüber dem Substrat (11) freizulegen, **dadurch gekennzeichnet, dass** die Dicke (d1) der im Bereich (A) der festen Elektroden (142) liegenden Opferschicht (91, 101) geringer ist, als die Dicke (d2) der im Bereich (B) der beweglichen Elektroden (143) liegenden Opferschicht (91, 101).

2. Verfahren nach Anspruch 1, **dadurch gekennzeichnet, dass** nach der Opferschichtätzung die Dicke (d3) der festen Elektroden (142) größer ist als die Dicke (d4) der beweglichen Elektroden (143).

3. Verfahren nach Anspruch 1 oder 2, **dadurch gekennzeichnet, dass** die unter dem Bereich (A) der festen Elektroden (142) liegende Opferschicht aus einer ersten Opferschicht (191) und die unter dem Bereich (B) der beweglichen Elektroden (143) liegende Opferschicht aus der ersten Opferschicht (91) und einer darüber liegenden zweiten Opferschicht (101) bestehen.

4. Verfahren nach einem der vorangehenden Ansprüche, **dadurch gekennzeichnet, dass** folgende Schritte aufeinanderfolgend ausgeführt werden:

   a) über dem Substrat (11) wird die erste Opferschicht (91) ganzflächig so aufgebracht, dass sie die Bereiche (A und B) der späteren festen und beweglichen Elektroden (142, 143) überdeckt;
   b) über der ersten Opferschicht (91) wird eine erste leitfähige Schicht (92) so aufgebracht, dass sie nur den Bereich (A) der späteren festen Elektroden (142) überdeckt;
   c) über der ersten Opferschicht (91) und der ersten leitfähigen Schicht (92) wird die zweite Opferschicht (101) ganzflächig so aufgebracht, dass sie die Bereiche (A und B) der späteren festen und beweglichen Elektroden (142, 143) überdeckt;
   d) die zweite Opferschicht (101) wird durch einen maskierten Ätzschritt über der ersten leitfähigen Schicht (42) geöffnet, so dass die erste leitfähige Schicht (92) freigelegt wird und die erste Opferschicht in der Tiefe nur geringfügig abgetragen wird;
   e) über der zweiten Opferschicht (101) und der in Schritt d) freigelegten leitfähigen Schicht (92) wird ganzflächig eine verhältnismäßig dicke dotierte Epitaxieschicht (131) bis zur Höhe der später zu bildenden festen und beweglichen Elektroden (142, 143) aufgebracht;
   f) auf der Oberfläche der Epitaxieschicht (131) wird eine die festen und beweglichen Elektroden (142, 143) strukturierende Maske (132, 133) aufgebracht, und unter Verwendung der Maske (132, 133) werden Gräben (141) in die Epitaxieschicht (131) bis in eine Tiefe geätzt, die im Bereich (A) der festen Elektroden (142) durch die Oberfläche der ersten Opferschicht (91) und im Bereich (B) der beweglichen Elektroden (143) durch die Oberfläche der zweiten Opferschicht (101) begrenzt ist, und
   g) die erste und zweite Opferschicht (91, 101) werden isotrop geätzt, wobei annähernd gleiche Unterätzraten der Opferschicht (91) unter den festen Elektroden (142) und der Opferschichten (91, 101) unter den beweglichen Elektroden (143) entstehen.

5. Verfahren nach einem der vorangehenden Ansprüche, **dadurch gekennzeichnet, dass** die Dicke (d1) der ersten Opferschicht (91) im Bereich von 0,5-5µm und die Dicke der zweiten Opferschicht (101) im Bereich von 0,5-3 µm liegen.

6. Verfahren nach einem der vorangehenden Ansprüche, **dadurch gekennzeichnet, dass** die Dicke (d3) der festen Elektroden (142) im Bereich von 1,5-20 µm liegt.

7. Verfahren nach einem der vorangehenden Ansprüche, **dadurch gekennzeichnet, dass** die festen und beweglichen Elektroden streifenförmig vorgesehen sind und die Elektrodenstreifen eine Breite im Bereich von 1 µm bis 5 µm haben.

**8.** Benutzung eines Verfahrens nach einem der Ansprüche 1 bis 7 zur Herstellung eines Beschleunigungssensors.

**Claims**

**1.** Method for the micromechanical fabrication of fixed and moving electrodes (141, 143) in layer form, which are uncovered over a certain region above a substrate (11) of a semiconductor element, in particular of a capacitive acceleration sensor, in which a sacrificial layer which is located between the substrate (11) and the fixed and moving electrodes (142, 143) is removed by an etching step in order to uncover the electrodes (142, 143) with respect to the substrate (11), **characterized in that** the thickness (d1) of the sacrificial layer (91, 101) located in the region (A) of the fixed electrodes (142) is less than the thickness (d2) of the sacrificial layer (91, 101) located in the region (B) of the moving electrodes (143).

**2.** Method according to Claim 1, **characterized in that** after the sacrificial layer etch the thickness (d3) of the fixed electrodes (142) is greater than the thickness (d4) of the moving electrodes (143).

**3.** Method according to Claim 1 or 2, **characterized in that** the sacrificial layer located beneath the region (A) of the fixed electrodes (142) comprises a first sacrificial layer (191), and the sacrificial layer located beneath the region (B) of the moving electrodes (143) comprises the first sacrificial layer (91) and a second sacrificial layer (101) located above it.

**4.** Method according to one of the preceding claims, **characterized in that** the following steps are carried out in succession:

a) the first sacrificial layer (91) is applied over the entire surface of the substrate (11), in such a way that it covers the regions (A and B) of what will subsequently be the fixed and moving electrodes (142, 143);
b) a first conductive layer (92) is applied over the first sacrificial layer (91), in such a way that it covers only the region (A) of what will subsequently be the fixed electrodes (142);
c) the second sacrificial layer (101) is applied over the entire surface of the first sacrificial layer (91) and the first conductive layer (92), in such a way that it covers the regions (A and B) of what will subsequently be the fixed and moving electrodes (142, 143);
d) the second sacrificial layer (101) is opened up over the first conductive layer (42) by means of a masked etching step, so that the first conductive layer (92) is uncovered and the first sacrificial layer is only slightly reduced in depth;
e) a relatively thick doped epitaxial layer (131) is applied over the second sacrificial layer (101) and the conductive layer (92) which has been uncovered in step
d) up to the height of the fixed and moving electrodes (142, 143) which are subsequently to be formed;
f) a mask (132, 133) which patterns the fixed and moving electrodes (142, 143) is applied to the surface of the epitaxial layer (131), and the mask (132, 133) is used to etch trenches (141) into the epitaxial layer (131) down to a depth which in the region (A) of the fixed electrodes (142) is limited by the surface of the first sacrificial layer (91) and in the region (B) of the moving electrodes (143) is limited by the surface of the second sacrificial layer (101), and
g) the first and second sacrificial layers (91, 101) are etched isotropically, producing approximately equal undercut etching rates for the sacrificial layer (91) beneath the fixed electrodes (142) and the sacrificial layers (91, 101) beneath the moving electrodes (143).

**5.** Method according to one of the preceding claims, **characterized in that** the thickness (d1) of the first sacrificial layer (91) is in the range from 0.5-5 μm and the thickness of the second sacrificial layer (101) is in the range from 0.5-3 μm.

**6.** Method according to one of the preceding claims, **characterized in that** the thickness (d3) of the fixed electrodes (142) is in the range from 1.5-20 μm.

**7.** Method according to one of the preceding claims, **characterized in that** the fixed and moving electrodes are provided in strip form, and the width of the electrode strips is in the range from 1 μm to 5 μm.

**8.** Use of a method according to one of Claims 1 to 7 for producing an acceleration sensor.

**Revendications**

**1.** Procédé de fabrication micromécanique d'électrodes fixes et mobiles (142, 143) d'un élément semiconducteur, notamment d'un capteur d'accélération capacitif, lesquelles électrodes sont en forme de couche mise à nu sur une zone spécifique sur un substrat (11), selon lequel une couche sacrifiée se trouvant entre le substrat (11) et les électrodes fixes et mobiles (142, 143) est retirée par une étape de gravure afin de mettre à nu les électrodes (142, 143) par rapport au substrat (11),

**caractérisé en ce que**

l'épaisseur (d1) de la couche sacrifiée (91, 101) se trouvant dans la zone (A) des électrodes fixes (142) est inférieure à celle (d2) de la couche sacrifiée (91, 101) se trouvant dans la zone (B) des électrodes mobiles (143).

2. Procédé selon la revendication 1,
   **caractérisé en ce qu'**
   après la gravure de la couche sacrifiée, l'épaisseur (d3) des électrodes fixes (142) est supérieure à l'épaisseur (d4) des électrodes mobiles (143).

3. Procédé selon la revendication 1 ou 2,
   **caractérisé en ce que**
   la couche sacrifiée se trouvant sous la zone (A) des électrodes fixes (142) se compose d'une première couche sacrifiée (191), et la couche sacrifiée se trouvant sous la zone (B) des électrodes mobiles (143) se compose de la première couche sacrifiée (91) et d'une deuxième couche sacrifiée (101) se trouvant sur la première.

4. Procédé selon l'une quelconque des revendications précédentes,
   **caractérisé en ce que**
   les étapes suivantes sont réalisées les unes à la suite des autres :

   a) la première couche sacrifiée (91) est appliquée sur toute la surface sur le substrat (11) de manière à recouvrir les zones (A et B) des futures électrodes fixes et mobiles (142, 143) ;
   b) une première couche conductrice (92) est appliquée sur la première couche sacrifiée (91) de manière à ne recouvrir que la zone (A) des futures électrodes fixes (142) ;
   c) la deuxième couche sacrifiée (101) est appliquée sur toute la surface sur la première couche sacrifiée (91) et la première couche conductrice (92) de manière à recouvrir les zones (A et B) des futures électrodes fixes et mobiles (142, 143),
   d) la deuxième couche sacrifiée (101) est ouverte par une étape de gravure masquée sur la première couche conductrice (92) de manière à ce que la première couche conductrice (92) soit mise à nu et que la première couche sacrifiée ne soit enlevée que légèrement en termes de profondeur ;
   e) une couche d'épitaxie (131) dopée et proportionnellement épaisse est appliquée sur toute la surface sur la deuxième couche sacrifiée (101) et la couche (92) conductrice mise à nu dans l'étape d) jusqu'à la hauteur des électrodes fixes et mobiles (142, 143) à former ultérieurement ;
   f) un masque (132, 133) structurant les électrodes fixes et mobiles (142, 143) est appliqué à la surface de la couche d'épitaxie (131) et des fosses (141) sont gravées en utilisant le masque dans la couche d'épitaxie (131) à une profondeur limitée par la surface de la première couche sacrifiée (91) dans la zone (A) des électrodes fixes (142) et par la surface de la deuxième couche sacrifiée (101) dans la zone (B) des électrodes mobiles (143) et
   g) la première et la deuxième couche sacrifiée (91, 101) sont gravées de manière isotropique, avec des taux de gravure sous-jacente quasiment identiques de la couche sacrifiée (91) sous les électrodes fixes (142) et ceux des couches sacrifiées (91, 101) sous les électrodes mobiles (143).

5. Procédé selon l'une quelconque des revendications précédentes,
   **caractérisé en ce que**
   l'épaisseur (d1) de la première couche sacrifiée (91) est comprise dans la plage de 0,5 - 5 µm et l'épaisseur de la deuxième couche sacrifiée (101) dans la plage de 0,5 - 3µm.

6. Procédé selon l'une quelconque des revendications précédentes,
   **caractérisé en ce que**
   l'épaisseur (d3) des électrodes fixes (142) est comprise dans la plage de 1,5 - 20 µm.

7. Procédé selon l'une quelconque des revendications précédentes,
   **caractérisé en ce que**
   les électrodes fixes et mobiles sont prévues sous forme de bandes, et les bandes d'électrodes ont une largeur de 1 µm à 5 µm.

8. Utilisation d'un procédé selon l'une quelconque des revendications 1 à 7, pour la fabrication d'un capteur d'accélération.

FIG.1

FIG. 2

Opferoxiddicke (bel. Einheiten)
(entspricht Spaltdicke)

FIG. 3A

FIG. 3B

FIG. 3C

FIG. 3D

FIG. 3E

FIG. 3F

## FIG. 3G

## FIG. 3H

FIG. 4